(19) Europäisches Patentamt
European Patent Office
Office européen des brevets

(11) **EP 2 421 043 B1**

(12) **EUROPEAN PATENT SPECIFICATION**

(45) Date of publication and mention
of the grant of the patent:
**18.06.2014 Bulletin 2014/25**

(51) Int Cl.:
*H01L 29/12* (2006.01)    *H01L 29/76* (2006.01)
*G06N 99/00* (2010.01)

(21) Application number: **10173610.6**

(22) Date of filing: **20.08.2010**

(54) **Quantum dot device**

Quantenpunktvorrichtung

Dispositif de points quantiques

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(43) Date of publication of application:
**22.02.2012 Bulletin 2012/08**

(73) Proprietor: **Hitachi Ltd.
Tokyo (JP)**

(72) Inventors:
• **Andreev, Alexey
  Cambridge, Cambridgeshire CB3 0HE (GB)**
• **Williams, David
  Cambridge, Cambridgeshire CB3 0HE (GB)**

(74) Representative: **Piotrowicz, Pawel Jan Andrzej et al
Venner Shipley LLP
200 Aldersgate
London EC1A 4HD (GB)**

(56) References cited:
**EP-A1- 1 262 911     EP-A1- 1 860 600
EP-A1- 2 075 745     EP-A2- 1 341 079**

• **TAKAHASHI N ET AL: "A directional current
switch using silicon single electron transistors
controlled by charge injection into silicon nano-
crystal floating dots", ELECTRON DEVICES
MEETING, 1999. IEDM TECHNICAL DIGEST.
INTERNATIONAL WASHINGTON, DC, USA 5-8
DEC. 1999, PISCATAWAY, NJ, USA,IEEE, US, 5
December 1999 (1999-12-05), pages 371-374,
XP010372047, DOI: DOI:10.1109/IEDM.
1999.824172 ISBN: 978-0-7803-5410-4**

## Description

The present invention relates to a quantum dot device.

Quantum dots are the subject of considerable theoretical and experimental investigation, particularly over the past two decades.

"A Directional Current Switch Using Silicon Single Electron Transistors Controlled by Charge Injection into Silicon Nano-Crystal Floating Dots", Nobuyoshi Takahashi, Hiroki Ishikuro and Toshiro Hiramoto, Electron Devices Meeting, 1999, IEDM Technical Digest, pages 371 to 374 (1999) describes a switch comprising two merged SETs. The switch comprises a single electron-transistor comprising a source, drain, and a point-contact channel in which a silicon dot is formed and a memory structure comprising silicon nano-crystal floating dots.

EP 1 341 079 A2 describes a random number generator.

One aspect of interest is the behaviour of a quantum dot in an external magnetic field. The behaviour of a single-particle energy levels in a quantum dot having a parabolic confining potential in an external magnetic field can be described by the Fock-Darwin diagram as shown in the Appendix of "Symmetry breaking and quantum correlations in finite systems: studies of quantum dots and ultracold Bose gases and related nuclear and chemical methods", C. Yannouleas and U. Landman, Reports on Progress in Physics, volume 70, pages 2067 to 2148 (2007).

Double quantum dot systems have also been investigated and reference is made to "Spin-orbit effects in single-electron states in coupled quantum dots", P. Stano and J. Fabian, Physical Review B, volume 72, page 155410ff. (2005), "Two-electron lateral quantum-dot molecules in a magnetic field", M. Helle, A. Harju, and R. M. Nieminen, Physical Review B, volume 72, page 205329ff. (2005), "Electron transport through double quantum dots", W. G. van der Wiel, S. De Franceschi, J. M. Elzerman, T. Fujisawa, S. Tarucha and L. P. Kouwenhoven, Reviews of Modern Physics 75, No. 1, pages 1 to 22 (2003), "Single-Electron Delocalization in Hybrid Vertical-Lateral Double Quantum Dots", T. Hatano, M. Stopa, S. Tarucha, Science, volume 309, page 268ff. (2005) and "Quantum Hall droplets in coupled lateral quantum dots", R. M. Abolfath, P. Hawrylak, M. Pioxo-Ladxiere, A. Sachrajda, Physica E, volume 34, pages 636 to 639 (2006). Reference is also made to ""Effect of a side-connected dot in a T-shaped double quantum dot interferometer" by S. Kawaguchi, Journal of Physics: Condensed Matter, volume 20, page 195205ff. (2008).

While double quantum dot systems are of interest, the prior art devices are primarily of research or theoretical interest.

However, uses for double quantum dot systems have been proposed, for example, such as for quantum information processing, as described in EP 1 262 911 A, EP 1 860 600 A and EP 2 075 745 A.

The present invention seeks to provide an improved quantum dot device.

According to a first aspect of the present invention there is provided a device comprising first and second conductive leads, a first quantum dot region arranged such that charge is transferable from the first lead to the second lead via the first quantum dot region, a second quantum dot region configured such that charge is transferable between the first and second quantum dot regions and such that charge is not directly transferable from second quantum dot region to the first or second leads or to another lead and a separate electrometer configured to detect charge on the second quantum dot region.

Thus, the quantum dots can be controllably populated with charge using the leads, charge can be redistributed between quantum dots by applying an external magnetic field and charge distribution within the quantum dots can be measured using the electrometer. Therefore, the device can provide, for example, a tuneable magnetic field sensor or detector.

The device may comprise first and second quantum dot regions spaced apart along a given direction and configured such that charge is transferable between the first and second quantum dot regions and such that charge is not directly transferable from second quantum dot region to a lead, a gate arrangement configured to apply an electrical field to the first and second quantum dots along the given direction and an electrometer configured to detect charge on the second quantum region.

The first and second quantum dot regions may comprise first and second regions of semiconductor material configured to provide first and second quantum dots respectively. The device may further comprise a third region of semiconducting material configured to couple the first and second quantum dot regions. The device may comprise a bridge region between the first and second quantum dot regions configured so as to provide at least one zero- or one-dimensional state freely extending from the first quantum dot region, through the bridge region, to the second quantum region.

The electrometer may comprise a single charge transistor, such as a single electron transistor.

The device may further comprise at least one additional quantum dot region including a third quantum dot region, the at least one additional quantum dot region configured such that charge is transferable between the first and third quantum dot regions via intermediate quantum dot region(s) and such that charge is not directly transferable from the intermediate quantum dot region(s) and the third quantum dot region to the first or second leads or to another lead, and wherein the electrometer is configured to detect charge on the third quantum region instead of the second quantum dot region.

The device may further comprise means, optionally gates, for decoupling the first and second conductive leads from the first quantum dot region. The device may further comprise means, optionally gates, for decoupling the first and second quantum dot regions.

The device may further comprise a magnetic field source configured to apply a magnetic field in a direction which is transverse to a direction in which the first and second quantum dot regions are spaced apart.

According to a second aspect of the present invention there is provided a quantum information processing apparatus comprising at least one device.

According to a third aspect of the present invention there is provided a magnetic head slider for a magnetic hard disk drive, the slider comprising the device.

According a fourth aspect of the present invention there is provided a method of operating a device comprising first and second conductive leads, a first quantum dot region arranged such that charge is transferable from the first lead to the second lead via the first quantum dot region, a second quantum dot region configured such that charge is transferable between the first and second quantum dot regions and such that charge is not directly transferable from second quantum dot region to the first or second leads or to another lead and a separate electrometer configured to detect charge on the second quantum region, the method comprising applying a bias between the first and second conductive leads, applying a magnetic field and measuring charge on the second quantum dot region using the electrometer

The method may further comprise, before applying the magnetic field, decoupling the first and second quantum dot regions and/or, before applying the magnetic field, decoupling the first and second conductive leads from the first quantum dot region and removing the bias between the first and second conductive leads, or removing the electric field.

According a fifth aspect of the present invention there is provided a method of operating a device comprising first and second quantum dot regions spaced apart along a given direction and configured such that charge is transferable between the first and second quantum dot regions and such that charge is not directly transferable from second quantum dot region to a lead, a gate arrangement configured to apply an electrical field to the first and second quantum dots along the given direction and an electrometer configured to detect charge on the second quantum region, the method comprising applying an electric field to the first and/or second quantum dot regions so as to raise or lower the potential of the first quantum dot region with respect to the second quantum dot region, applying a magnetic field and measuring charge on the second quantum dot region using the electrometer.

Thus, the quantum dots can be tuned using an external electric field, charge can be redistributed between quantum dots by applying an external magnetic field and charge distribution within the quantum dots can be measured using the electrometer. Therefore, the device can provide, for example, a tuneable magnetic field sensor or detector.

Certain embodiments of the present invention will now be described, by way of example, with reference to the accompanying drawings in which:

Figure 1 illustrates the behaviour of atomic energy levels in a weak magnetic field;
Figures 2a and 2b are schematic diagrams of a double quantum dot system with excess charge on first and second quantum dots respectively;
Figure 2c is a schematic plot of energy against magnetic field for a double quantum dot system;
Figure 2d is a schematic plot of charge difference against magnetic field for a double quantum dot system;
Figures 3a and 3b are schematic plots of energy against magnetic field for a double quantum dot system for first and second numbers of electrons respectively;
Figures 4a and 4b are schematic plots of energy against magnetic field for a double quantum dot system in the absence and presence of an applied electric field respectively;
Figures 5a and 5b schematically show potential diagrams of a double quantum dot system in the absence and presence of an applied electric field respectively;
Figure 6 is a schematic diagram of a first embodiment of a device in accordance with the present invention and associated circuitry;
Figure 6a illustrates a magnetic field source in the form of a coil and current source;
Figure 6b illustrates a magnetic field source in the form of a bit of magnetic hard disk drive media;
Figure 7 is a plan view of the device shown in Figure 6;
Figure 8 is a sectional view of the device shown in Figure 7 taken along the line A-A';
Figures 9a to 9o illustrate the device shown in Figures 7 and 8 at stages during fabrication;
Figure 10 is a schematic diagram of a second embodiment of a device in accordance with the present invention and associated circuitry;
Figure 11 is a plan view of the device shown in Figure 10;
Figure 12 is a sectional view of the device shown in Figure 11 taken along the line B-B';
Figures 13a to 13e illustrate the device shown in Figures 11 and 12 at different stages during fabrication;

Figure 14 is a schematic plot of energy against magnetic field for a double quantum dot system illustrating a working point;

Figure 15 is a process flow diagram of a method of operating the device;

Figure 16 is a perspective view of a slider for use in a magnetic hard disk drive and into which is incorporated an embodiment of a device in accordance with the present invention;

Figure 17 is a schematic plan view of a magnetic hard disk drive;

Figure 18 is a schematic plot of energy against magnetic field for a double quantum dot system illustrating a working point and oscillation between two states during quantum information processing;

Figure 19 is a plan view of third embodiment of a device in accordance with the present invention;

Figure 20 is a plan view of fourth embodiment of a device in accordance with the present invention;

Figure 21 is a plan view of fifth embodiment of a device in accordance with the present invention; and

Figure 22 is a plan view of sixth embodiment of a device in accordance with the present invention.

*Energy levels in a magnetic field*

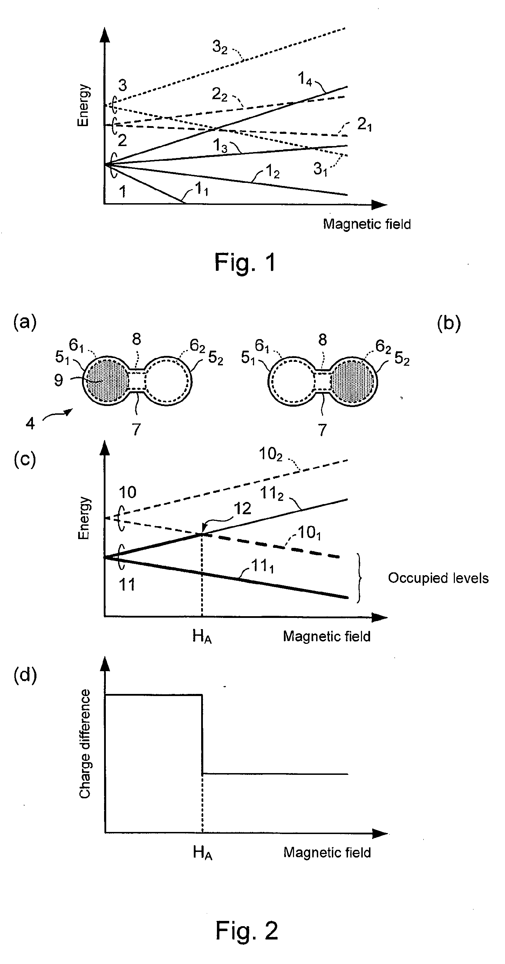

Figure 1 schematically illustrates the behaviour of three energy levels 1, 2, 3 of an atom (not shown) in a weak magnetic field, H. Each energy level 1, 2, 3 can be described by a set of quantum numbers, namely total momentum, $J$, angular moment, L, total spin, S, and magnetic quantum number, $M_J$.

The shift in energy, ΔE, of an energy level 1, 2, 3 is given by equation 1 below, with the Landé factor, g, given by equation 2 below, namely:

$$\Delta E = \mu_B \, g \, M_J \, H \qquad (1)$$

$$g = 1 + \frac{J(J+1) - L(L+1) + S(S+1)}{2J(J+1)} \qquad (2)$$

where $\mu_B$ is the Bohr magneton.

According to equations 1 and 2 above, atomic energy levels 1, 2, 3 having different quantum numbers can respond differently to a magnetic field. As shown in Figure 1, an energy level 1, 2, 3 can split and can rise or fall in energy. A first energy level 1 having the lowest energy of the three energy levels 1, 2, 3, for example, can split into first, second, third and fourth non-degenerate energy levels $1_1$, $1_2$, $1_3$, $1_4$ with the first and second non-degenerate levels $1_1$, $1_2$ falling in energy as magnetic field increases and the third and fourth non-degenerate energy levels $1_3$, $1_4$ rising in energy as magnetic field increases. A second energy level 2 having the next lowest energy, for example, can split into fifth and sixth non-degenerate energy levels $2_1$, $2_2$ whose energies rise and fall respectively with increasing magnetic field. Likewise, the third energy level 3 having the highest energy, for example, can split into fifth and sixth non-degenerate energy levels $3_1$, $3_2$ whose energies rise and fall respectively with increasing magnetic field. Thus, as shown in Figure 1, energy levels 1, 2, 3 can split and cross as the magnetic field, H, changes.

*Double quantum dot system*

Figure 2a and 2b illustrates a double quantum dot system 4. The double quantum dot system 4 includes first and second quantum dot regions $5_1$, $5_2$ providing first and second quantum dots $6_1$, $6_2$ respectively and a coupling region 7 providing a link or coupling 8 between the quantum dots $6_1$, $6_2$. For example, the double quantum dot system 4 can be arranged to provide bridge coupling between the quantum dots $6_1$, $6_2$ as described in EP 1 860 600 A *supra*. The double quantum dot system 4 can be considered to be an artificial molecule.

If the quantum dots $6_1$, $6_2$ are weakly coupled, then an excess electron 9 can be localised on one of the quantum dots $6_1$, $6_2$ and occupy the lowest-available energy level of that quantum dot $6_1$, $6_2$. In Figure 2a, an electron 9 is shown localised to the first quantum dot $6_1$ shown on the left. In Figure 2b, the electron 9 is shown localised to the second quantum dot $6_2$ shown on the right.

The energy spectrum of the double quantum dot system 4 can be represented as a collection of two sets of energy levels, one for each dot $6_1$, $6_2$. Thus, a level in each set corresponding to an electron localised to one of the quantum dots $6_1$, $6_2$.

Figure 2c schematically illustrates, for the double quantum dot system 4 shown in Figures 2a and 2b, the behaviour of an energy level 10 (e.g. a ground state) of the left quantum dot $6_1$ and an energy level 11 (e.g. ground state) of the right quantum dot $6_2$ in a weak magnetic field, $H$.

As shown in the Figure 2c, the energy level 10 of the left quantum dot $6_1$ can spit into first and second non-degenerate energy levels $10_1$, $10_2$ which rise and fall in energy respectively with increasing magnetic field. Likewise, the energy level 11 of the right quantum dot $6_2$ can split into first and second non-degenerate energy levels $11_1$, $11_2$ which also rise and fall in energy respectively with increasing magnetic field.

As shown in Figure 2c, the energy of the lower $10_1$ of the two non-degenerate energy levels $10_1$, $10_2$ of the left quantum dot $6_1$ can fall below the energy of the higher $11_1$ of the two non-degenerate energy levels $11_1$, $11_2$ of the right quantum dot $6_2$ at a crossing point 12 when the magnetic field has a value $H_A$.

The double quantum dot system 4 is populated with a given number, N, of electrons. If the thermal energy, $k_B T$ of the system is sufficiently small compared with the separation of the energy levels, i.e. $k_B T < \delta E$ (where $k_B$ is Boltzmann's constant and T is temperature in Kelvin), then the system 4 can be viewed as a collection of levels in which the lowest N levels are occupied, while higher energy levels are unoccupied.

Thus, as shown in Figure 2c, below $H_A$, two electrons can occupy the (degenerate) energy level 11 or the two non-degenerate energy levels $11_1$, $11_2$ of the right quantum dot $6_2$. As shown in Figure 2d, this arrangement results in a polarized double quantum dot system 4. When the magnetic field reaches $H_A$, then an electron 9 can move from the higher-energy, non-degenerate energy level $11_2$ of the right quantum dot $6_2$ to the lower-energy, non-degenerate energy level $10_1$ of the left quantum dot $6_1$. This results in a change in the amount of charge held by each quantum dot $6_1$, $6_2$ and, thus, a change in polarization. Thus, applying an appropriate magnetic field can induce a change or variation in charge distribution. This behaviour is effectively a zero-dimensional Hall effect since a magnetic field can be used to induce a variation in charge distribution in a zero-dimensional system and the variation in charge distribution can be detected.

By measuring the charge on one of the quantum dots $6_1$, $6_2$ using a charge sensor, such as a single electron transistor or quantum point contact, the double quantum dot system 4 can be used as a magnetic field sensor or detector. However, as will be explained later, the double quantum dot system 4 can also be used in quantum information processing and other applications.

Although the quantum dots $6_1$, $6_2$ can be coupled via a tunnel barrier or other type of coupling, coupling via a bridge, for example as described in EP 1 860 600 A *supra,* is preferred.

Coupling via a tunnel barrier, particularly for a low, thin barrier, can have the drawback that, as energy of an electron within a quantum dot increases, coupling between the quantum dot and the neighbouring quantum dot can increase sharply. This can limit the degree of polarization.

Bridge coupling occurs through quantised states and has the ability to provide coupling over much longer distances than the width of a tunnel barrier. Thus, the bridge can be considered to be non-transmissive across a broad range of energy except at certain sharply-defined energies. Thus, even as energy of an electron within a quantum dot increases, coupling between the quantum dot and the neighbouring quantum dot can still be sufficiently suppressed. Therefore, the quantum dots system 4 can still be highly polarised even at higher energies.

Charge movement between two quantum dots $6_1$, $6_2$ can be caused or induced in a number of different ways. Firstly, charge can move between quantum dots $6_1$, $6_2$ by increasing the number of charge carriers in the double quantum dot system 4. Secondly, charge can move as a result of changing electrical potential distribution within the double quantum dot system 4 which shifts the energy levels of the two quantum dots $6_1$, $6_2$ with respect to each other.

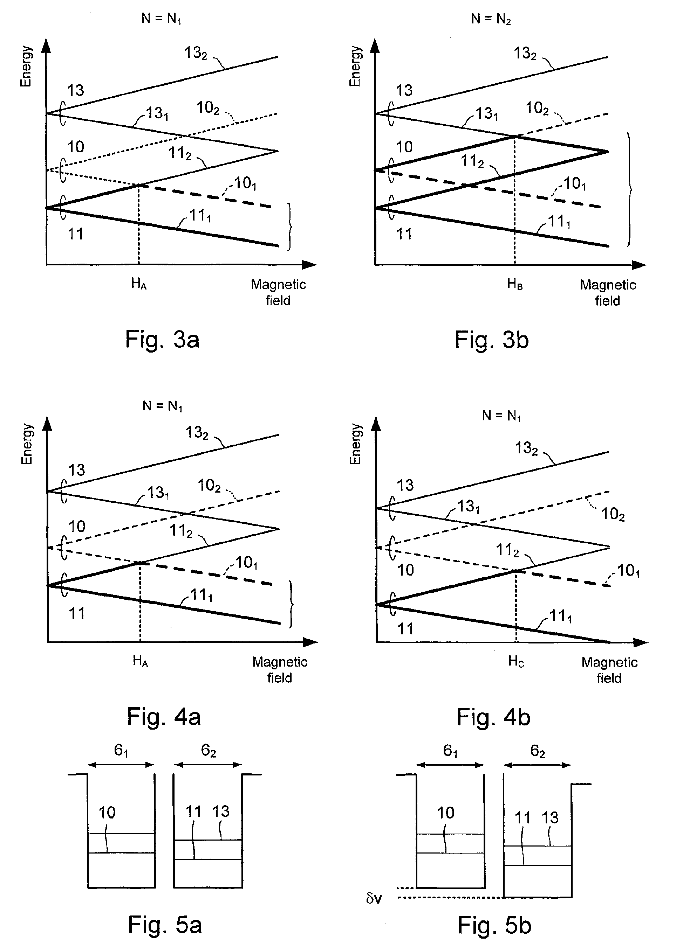

Figures 3a and 3b are schematic diagrams of energy against magnetic field for the double quantum dot system 4 having different numbers of electrons. Figures 3a and 3b show not only the previously-shown energy levels 10, 11 of the left and right quantum dots $6_1$, $6_2$, but also the next highest energy level 13 (e.g. a first excited state) of the right quantum dot $6_2$.

Referring in particular to Figure 3a, for $N_1$ electrons in the double dot system 4, the energy of the lower $10_1$ of the two non-degenerate energy levels $10_1$, $10_2$ of the left hand quantum dot $6_1$ can fall below the energy of the higher $11_1$ of the two non-degenerate energy levels $11_1$, $11_2$ of the right hand quantum dot $6_2$ when the magnetic field has a value $H_A$ resulting in a change of the charge distribution in the dot system.

For a different number of electrons, levels can cross at another, different magnetic field. For example, as shown in Figure 3b, for $N_2$ electrons (where $N_1 < N_2$), the energy of the higher non-degenerate energy level $10_2$ for the left hand quantum dot $6_1$ rises above a lower non-degenerate energy level $13_1$ of the next highest level 13 of the right hand quantum dot $6_2$ when the magnetic field has a value $H_B$.

Thus, by varying the population of electrons in the double quantum dot system 4, the system 4 can be tuned to detect different magnitudes and/or orientation of magnetic field.

Figures 4a and 4b are schematic diagrams of energy against magnetic field for the double quantum dot system 4 in the absence and presence of an applied electric field. Figures 4a and 4b also show the next highest energy level 13 of the right quantum dot $6_2$. Figures 5a and 5b show potential diagrams of the double quantum dot system 4 in the absence and presence of an applied electric field.

As shown in Figure 4a, in the absence of an applied electric field, the lower-energy, non-degenerate energy

level $10_1$ of the left hand quantum dot $6_1$ can fall below the higher-energy, non-degenerate level $11_1$ of the right hand quantum dot $6_2$ when the magnetic field has a value $H_A$.

However, as shown in Figure 4b, in the presence of an applied electric field, the lower-energy, non-degenerate energy level $10_1$ of the left hand quantum dot $6_1$ can fall below the higher-energy, non-degenerate level $11_1$ of the right hand quantum dot $6_2$ when the magnetic field has a value $H_c$ ($H_A \neq H_c$).

Thus, by applying an electric field to the double quantum dot system 4, the system 4 can be tuned to detect different magnitudes and/or orientation of magnetic field.

Examples of devices will now be described which comprise two or more quantum dots which be tuned and in which charge can redistributed between quantum dots by applying an external magnetic field and measured using a charge sensor.

*Fist embodiment*

Device structure

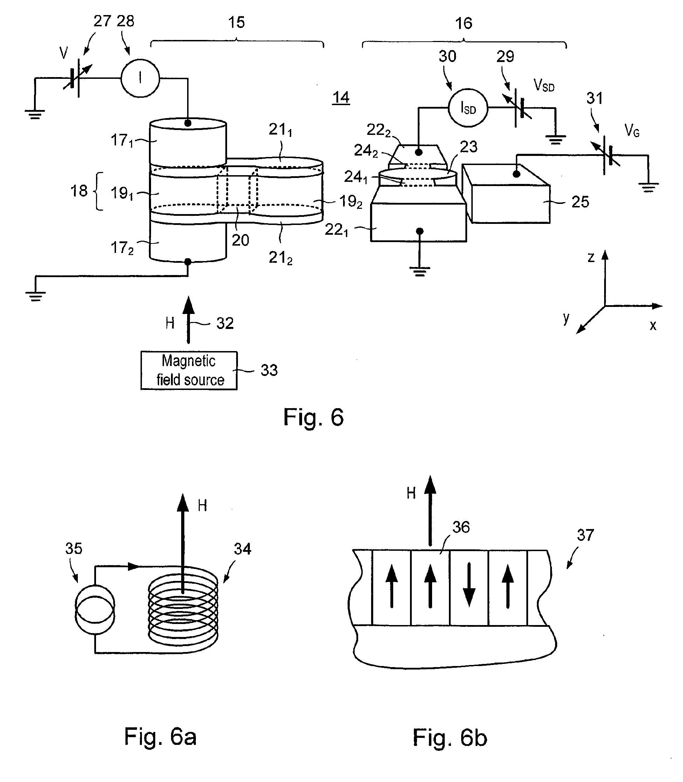

Referring to Figure 6, a first embodiment of a device which is responsive to a magnetic field in accordance with the present invention and associated control circuitry are shown. In Figure 6, elements of the device 14 are shown in perspective, while the control circuitry is shown in schematic circuit diagram form.

The device 14 includes a first portion 15 in which charge can be transferred and a second portion 16 which detects charge distribution in the first portion 15 of the device 14.

The first portion 15 of the device 14 includes first and second conductive leads $17_1$, $17_2$, a double-quantum dot system 18 comprising first and second quantum dot regions $19_1$, $19_2$ and a coupling region 20 which is interposed between the quantum dot regions $19_1$, $19_2$, and first and second insulating regions $21$, $21_2$ which are interposed between the first conductive lead $17_1$ and the double-quantum dot system 18 and the second conductive lead $17_2$ and the double-quantum dot system 18 respectively.

As shown in Figure 6, the first portion 15 of the device 14 is generally shaped like a letter 'T' placed on its side so that its stem lies horizontally and its cross-piece runs vertically.

The first and second quantum dot regions $19_1$, $19_2$ are spaced apart along a first direction (labelled as the x-axis). The first and second quantum dot regions $19_1$, $19_2$ and the interposed coupling region 20 are co-planar and, thus, the first and second quantum dot regions $19_1$, $19_2$ are laterally spaced apart. As will be explained later, the first and second quantum dot regions $19_1$, $19_2$ and the interposed coupling region 20 can be formed in a single layer of semiconductor material.

The double quantum dot system 18 is sandwiched between the first and second insulating regions $21_1$, $21_2$. The first and second insulating regions $21_1$, $21_2$ are layers and form part of a vertical stack. The first and second conductive leads $17_1$, $17_2$ are spaced apart along a second direction (labelled as the z-axis) which is perpendicular to the first direction and which corresponds to the axis of growth or deposition. The first quantum dot region $19_1$, but not the second quantum dot region $19_2$, is sandwiched between the conductive leads $17_1$, $17_2$. The parts of the insulating layers $21_1$, $21_2$ which lie between a conductive lead $17_1$, $17_2$ and the first quantum dot region $19_1$ provide tunnel barriers. Thus, charge is transferable from the first conductive lead $17_1$ to the second conductive lead $17_2$ via the first insulating layer $21_1$, the first quantum dot region $19_2$ and the second insulating layer $21_2$. The first quantum dot region $19_1$ serves as node through which charge is transferable to and from the first conductive lead $17_1$ and/or the second conductive lead $17_2$ and through which charge is transferable to and from the second quantum dot region $19_2$ which, but for the first quantum dot region $19_1$ and the coupling region 20, would otherwise be isolated.

The second portion 16 of the device 14 takes the form of a single-electron transistor and includes first and second conductive leads $22_1$, $22_2$, an island region 23, first and second tunnel barrier regions $24_1$, $24_2$ and a gate 25. Configuration and operation of the single-electron transistor is described, for example, in EP 1 262 911 A and EP 1 860 600 A.

As shown in Figure 6, the device 14 is controlled and measured using circuitry which includes a voltage source 27 for applying a bias, V, between the conductive leads $17_1$, $17_2$ and a current meter 28 for measuring the current flowing through the device between the leads $17_1$, $17_2$. The circuitry also includes a voltage source 29 for applying a bias, $V_{SD}$, between the conductive leads $22_1$, $22_2$ of the single-electron transistor, a current meter 30 for measuring the current flowing through the single-electron transistor and another voltage source 31 for applying a bias, $V_G$, to the gate 22.

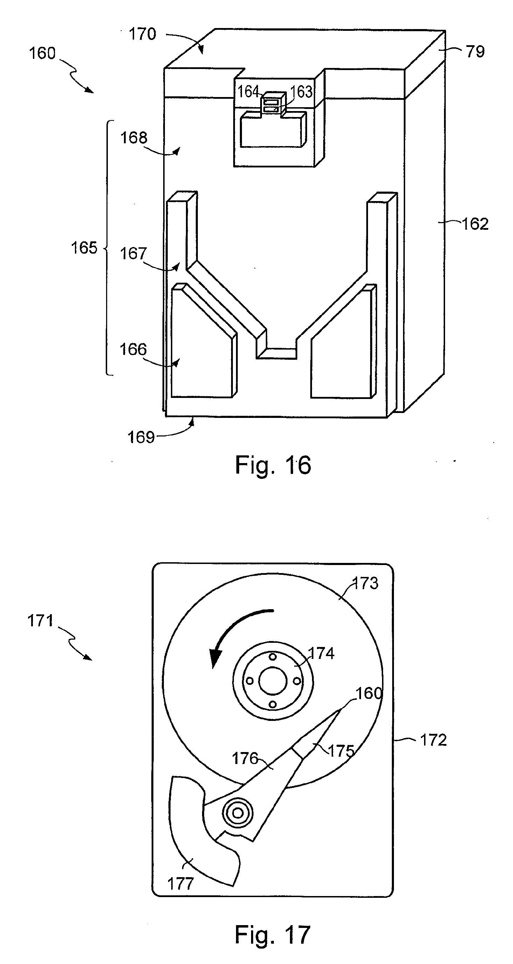

The device 14 can be used to detect or measure a magnetic field 32 originating from a source 33. As shown in Figure 6a, the magnetic field source can take the form of a coil 34 and a current source 35. As shown in Figure 6b, the magnetic field source can take the form of a grain or other region 36 in a magnetic recording medium 37 of a magnetic hard disk drive 171 (Figure 17).

As shown in Figure 6, the magnetic field 32 is orientated so that it parallel to direction of current flow between the leads $17_1$, $17_2$ through the first quantum dot region $22_1$ and perpendicular to the direction in which the first and second quantum dot regions $22_1$, $22_2$ are spaced.

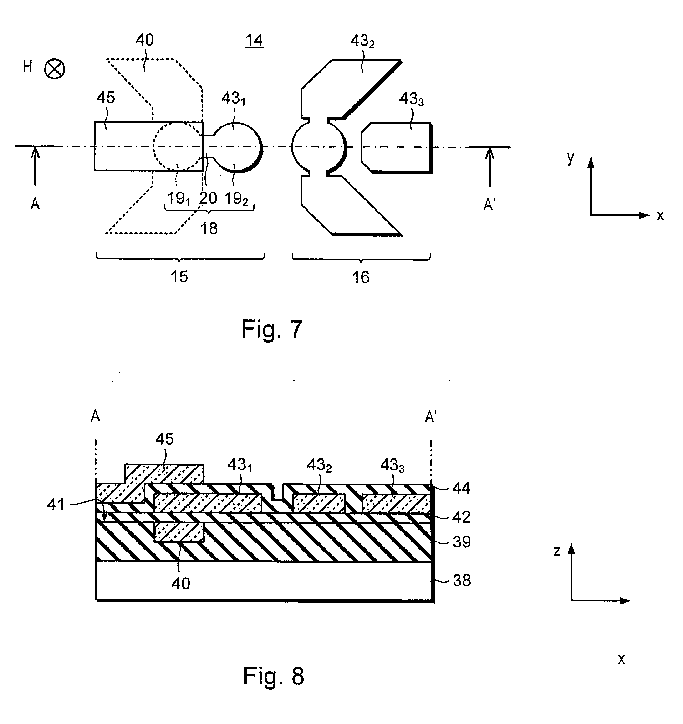

Referring to Figures 7 and 8, the device 14 is shown in more detail.

A substrate 38, for example formed of p-type silicon, supports a thick layer 39 (e.g. > 200 nm) of insulating material, such as silicon dioxide. A conductive track 40 comprising n-type poly-crystalline silicon is embedded in the insulating layer 39 at its surface so that the insulating layer 39 and conductive track 40 are flush and form a flat surface 41. The conductive track 40 can have a thickness of between about 50 to 200 nm. The conductive track 40 provides one of leads $17_2$ of the device 14.

The insulating layer 39 and the conductive track 40 are covered by a first thin layer 42 (e.g. about 3 to 10 nm) of insulating material, such as silicon oxide or silicon nitride. The first thin insulating layer 42 provides one of the insulating regions $21_2$ of the device 14. The thickness of the layer 42 depends on the insulating material used. Generally, the layer 42 provides a tunnel barrier whose width (which corresponds to the thickness of the layer 42) and height (which depends on the material) result in a barrier having a resistance which is greater than the quantum resistance, $R_K$ (about 26 k$\Omega$) and provides sufficiently low leakage.

The insulating layer 42 supports first, second and third delineated regions or films $43_1$, $43_2$, $43_3$ formed from a layer of semiconducting material, such as intrinsic or n-type, poly- or mono-crystalline silicon. The layer of semiconducting material has a thickness of about 20 nm.

The first semiconductor layer region $43_1$ is generally bi-lobate (or "dumbbell-shaped") and provides the quantum dot regions $19_1$, $19_2$ and the coupling region 20. The first semiconductor layer region $43_1$ has dimensions the same or similar to those described in EP 1 860 600 A *supra.*

The second semiconductor layer region $43_2$ provides the conductive leads $22_1$, $22_2$, island region 23 and tunnel barrier regions $24_1$, $24_2$ of the single-electron transistor. The third semiconductor layer region $43_3$ provides the gate 25 of the single-electron transistor. The first and second semiconductor layer regions $43_1$, $43_2$ can have dimensions the same or similar to those described in EP 1 860 600 A *supra.*

The exposed regions of the insulating layer 42 and the semiconducting layer regions $43_1$, $43_2$, $43_3$ are covered by a second thin layer 44 of insulating material, such as silicon oxide or silicon nitride. The second thin insulating layer 44 provides one of the insulating regions $21_1$ of the device 14.

A conductive track 45 in the form of a delineated film or layer of n-type poly-crystalline silicon runs over the second thin insulating layer 44 terminating over one of the lobes of the first semiconductor layer region $43_1$, i.e. the part which provides the first quantum dot region. The conductive track 45 can have a thickness of between about 50 to 200 nm and provides one of leads $17_1$ of the device 14.

Fabrication

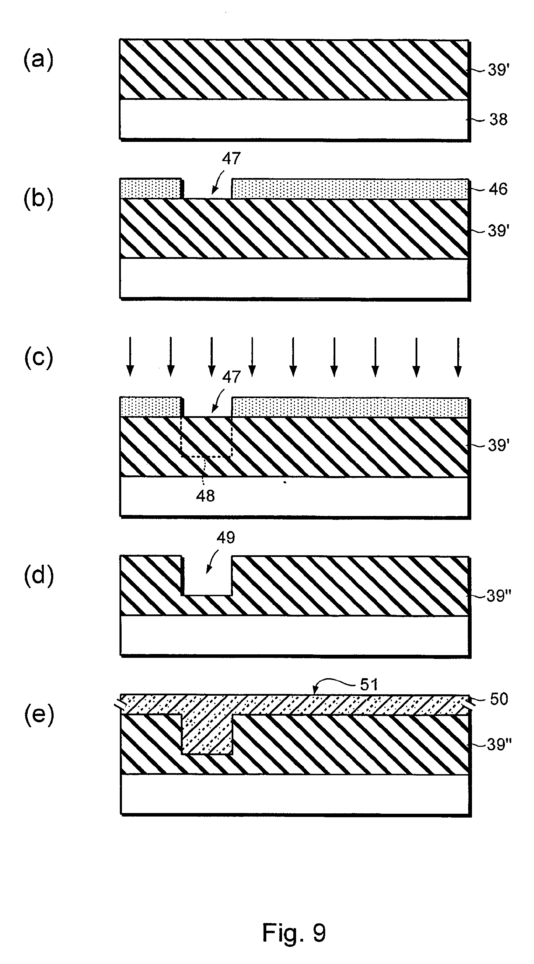

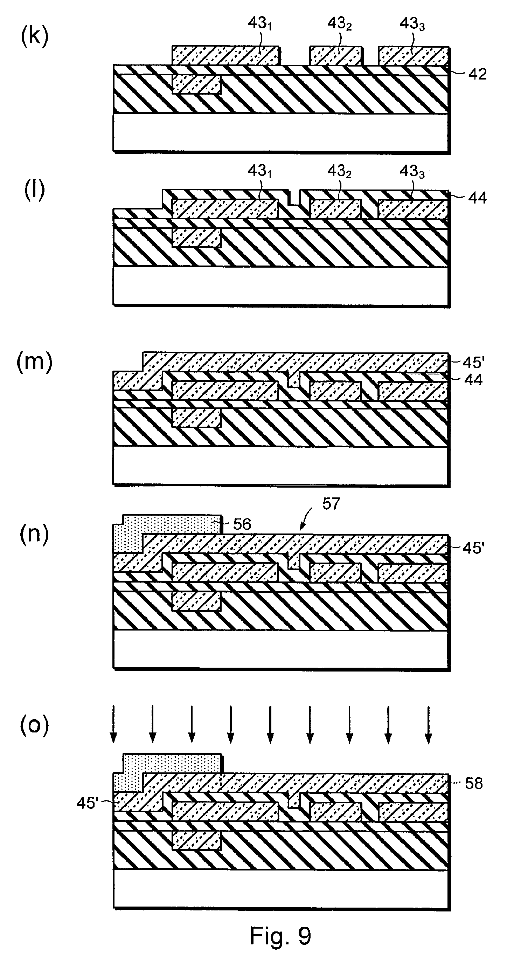

Referring to Figures 9a to 9o, a method of fabricating the device 14 will now be described.

As shown in Figure 9a, a thick layer 39' (e.g. 500 nm) of insulating material, such as silicon dioxide, is formed on a substrate 38, for example by wet oxidation or chemical vapour deposition.

A layer of electron-beam resist is deposited, exposed and developed. As shown in Figure 9b, this leaves a patterned resist layer 46 having a window 47 on the insulating layer 39'.

Referring to Figures 9c & 9d, reactive ion etching is used to partially etch the insulating layer 39' by removing a portion 48 of the insulating layer 39' in the window 47. As shown in Figure 9d, etching leaves a trench 49 having a depth, for example, of about 400 nm in an etched insulating layer 39".

Referring to Figure 9e, a thick (e.g. 500 nm) layer 50 of conductive material, for example highly-doped n-type poly-crystalline silicon, is deposited over the etched insulating layer 39", for instance, using chemical vapour deposition. The layer 50 is deposited under conditions (e.g. temperature, pressure and choice of chemical precursors) which result in the layer 50 planarising the etched insulating layer 39" . The layer 50 can have a flat or nearly flat upper surface 51.

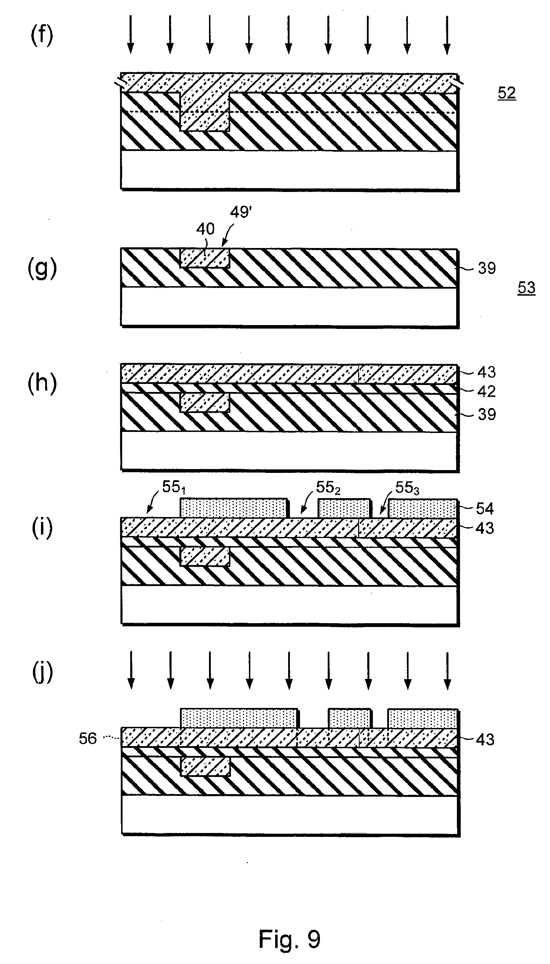

Referring to Figures 9f and 9g, the resulting structure 52 is etched back to leave conductive material 40 which fills a trench 49' (which is now shallower) in the insulating layer 39. For example, etch back may be achieved by using an unmasked, unselective, isotropic etch.

The resulting structure 52 shown in Figure 9g can be achieved in other ways. For example, a silicon-on-insulator substrate may be patterned and etched to remove regions of silicon and leave a conductive track. The structure may then be planarised.

Referring to Figure 9h, a thin (e.g. about 3 to 10 nm) layer 42 of dielectric material, such as silicon dioxide, is deposited by chemical vapour deposition or by sacrificially converting (e.g. oxidizing) a surface layer of the conductive material 40.

A layer 43 of semiconductor material is deposited on the thin layer 42 of dielectric material. In this example, silicon is used and can be deposited by chemical vapour deposition, for example, using silane ($SiH_4$). The semiconductor material may be undoped or doped (n- or p-type) comprising mono- or poly-crystalline material. Even if polycrystalline material is used, the layer may be deposited under conditions such that the crystal grain size is of the order 100 nm to

1 $\mu$m and so that the crystal grain size is larger than the first semiconductor layer region $43_1$ (Figure 8) thereby making the first semiconductor layer region $43_1$ (Figure 8) effectively single crystal.

Referring to Figure 9i, a layer of electron-beam resist is deposited, exposed and developed to leave a patterned resist layer 54 having windows $55_1$, $55_2$, $55_3$ on the semiconductor layer 43.

Referring to Figures 9j and 9k, reactive ion etching is used to remove unwanted portions 56 of the semiconductor layer 43. As shown in Figure 9k, etching leaves layer regions $43_1$, $43_2$, $43_3$ on thin insulating layer 42.

Referring to Figures 9I, a thin (e.g. about 3 to 10 nm) layer 44 of dielectric material, such as silicon dioxide or silicon nitride, is deposited over the semiconductor layer regions $43_1$, $43_2$, $43_3$ and the underlying lower dielectric layer 43, for example by chemical vapour deposition or by sacrificially converting (e.g. oxidizing) a surface layer of the semiconductor layer regions $43_1$, $43_2$, $43_3$.

Referring to Figures 9m, a layer 45' of conductive material is deposited on the upper dielectric layer 44. The conductive material may be highly-doped n-type poly-crystalline silicon and deposited using chemical vapour deposition, e.g. using silane. However, the layer can be a metal or metal alloy, such as aluminium (Al).

Referring to Figure 9n, a layer of electron-beam resist is deposited, exposed and developed to leave a patterned resist layer 56 on the semiconductor layer 45'. The resist 56 leaves an area 57 of the semiconductor layer 45' unmasked.

Referring to Figure 9o, reactive ion etching is used to remove unwanted portions 58 of the semiconductor layer 45' and so define a conductive track 45 (Figure 8) which provides conductive lead $17_1$ (Figure 6).

The conductive track 45 (Figure 8) can be formed using lift-off process.

*Second embodiment*

Device structure

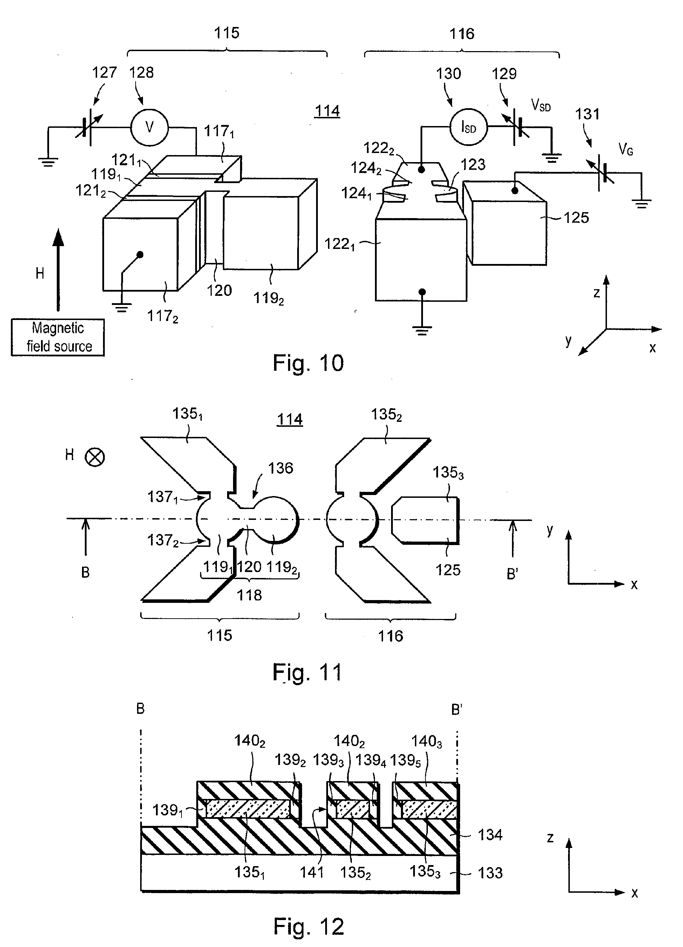

Referring to Figure 10, a second embodiment of a device which is responsive to a magnetic field in accordance with the present invention and associated control circuitry are shown. In Figure 10, elements of the device 114 are shown in perspective, while the control circuitry is shown in schematic circuit diagram form.

The device 114 is similar to the device 14 (Figure 6) described earlier. The device 114 includes a first portion 115 in which charge can be transferred and a second portion 116 which detects charge distribution in the first portion 115 of the device 114.

The first portion 115 of the device 114 includes first and second conductive leads $117_1$, $117_2$, a double-quantum dot system 118 comprising first and second quantum dot regions $119_1$, $119_2$ and a coupling region 120 which is interposed between the quantum dot regions $119_1$, $119_2$, and first and second barrier regions $121_1$, $121_2$ which are interposed between the first conductive lead $117_1$ and first quantum dot region $119_1$ and the second conductive lead $117_2$ and first quantum dot region $119_1$ respectively.

As shown in Figure 6, the first portion 115 of the device 114, in this example, is generally shaped like a letter 'T' placed on its back so that its stem and cross-piece lie horizontally.

The first and second quantum dot regions $119_1$, $119_2$ are spaced apart along a first direction (labelled as the x-axis). The first and second quantum dot regions $119_1$, $119_2$ and the interposed coupling region 120 are co-planar and, thus the first and second quantum dot regions $119_1$, $119_2$ are laterally spaced apart. As will be explained in more detail later, the first and second conductive leads $117_1$, $117_2$, the first and second quantum dot regions $119_1$, $119_2$ and the interposed coupling region 120 can be formed in a single layer of semiconductor material.

The first and second conductive leads $117_1$, $117_2$ are spaced apart along a third, orthogonal direction, namely the y-axis. The x- and y-axes lie in a plane perpendicular to the axis of growth or deposition, i.e. the z-axis.

The first quantum dot region $119_1$ serves as node through which charge is transferable to and from the first conductive lead $117_1$ and/or the second conductive lead $117_2$ and through which charge is transferable to and from the second quantum dot region $119_2$ which, but for the first quantum dot region $119_1$ and the coupling region 120, would otherwise be isolated.

The second portion 116 of the device 114 takes the form of a single-electron transistor and includes first and second conductive leads $122_1$, $122_2$, an island region 23, first and second tunnel barrier regions $124_1$, $124_2$ and a gate 125.

The device 114 is controlled and measured using circuitry which includes a voltage source 127 for applying a bias, V, between the conductive leads $117_1$, $117_2$ and a current meter 128 for measuring the current flowing through the device between the leads $117_1$, $117_2$. The circuitry also includes a voltage source 129 for applying a bias, $V_{SD}$, between the conductive leads $122_1$, $122_2$ of the single-electron transistor, a current meter 130 for measuring the current flowing through the single-electron transistor and another voltage source 129 for applying a bias, $V_G$, to the gate 122.

The device 114 can be used to detect or measure a magnetic field 130 originating from a source 131

As shown in Figure 10, the magnetic field 132 is orientated so that it parallel to direction of current flowing through the first quantum dot region $122_1$ and perpendicular to the direction in which the first and second quantum dot regions $122_1$, $122_2$ are spaced.

Referring to Figures 11 and 12, the device 114 is shown in more detail.

A substrate 133, for example formed of p-type silicon, supports a thick layer 134 (e.g. > 200 nm) of insulating material, such as silicon dioxide.

The insulating layer 134 supports first, second and third regions $135_1$, $135_2$, $135_3$ of semiconducting material, such as intrinsic or n-type, poly- or mono-crystalline silicon. The semiconducting regions have a thickness of about 20 nm.

The first semiconductor layer region $135_1$ includes a bi-lobate (or "dumbbell-shaped") portion 136 which provides the quantum dot regions $119_1$, $119_2$ and the coupling region 120. The bi-lobate portion 136 has dimensions similar to those described in EP 1 860 600 A *supra.* The first semiconductor layer region $135_1$ also provides the conductive leads $117_1$, $117_2$ and tunnel barriers $121_1$, $121_2$. As shown in Figure 11, the tunnel barriers $121_1$, $121_2$ are formed by constrictions $137_1$, $137_2$.

The second semiconductor layer region $135_2$ provides the conductive leads $122_1$, $122_2$, island region 123 and tunnel barrier regions $124_1$, $124_2$ of the single-electron transistor. The third semiconductor layer region $135_3$ provides the gate 125 of the single-electron transistor. The second and third semiconductor layer regions $135_2$, $135_3$ can have dimensions similar to those described in EP 1 860 600 A *supra.*

The semiconductor layer regions $135_1$, $135_2$, $135_3$ are encapsulated by side regions $139_1$, $139_2$, $139_3$, $139_4$, $139_5$ of insulating material and top regions $140_1$, $140_2$, $140_3$ of insulating material. As will be explained later, the side insulating regions $139_1$, $139_2$, $139_3$, $139_4$, $139_5$ are formed by sacrificial conversion, e.g. oxidation, of the semiconductor material at side walls 141.

Fabrication

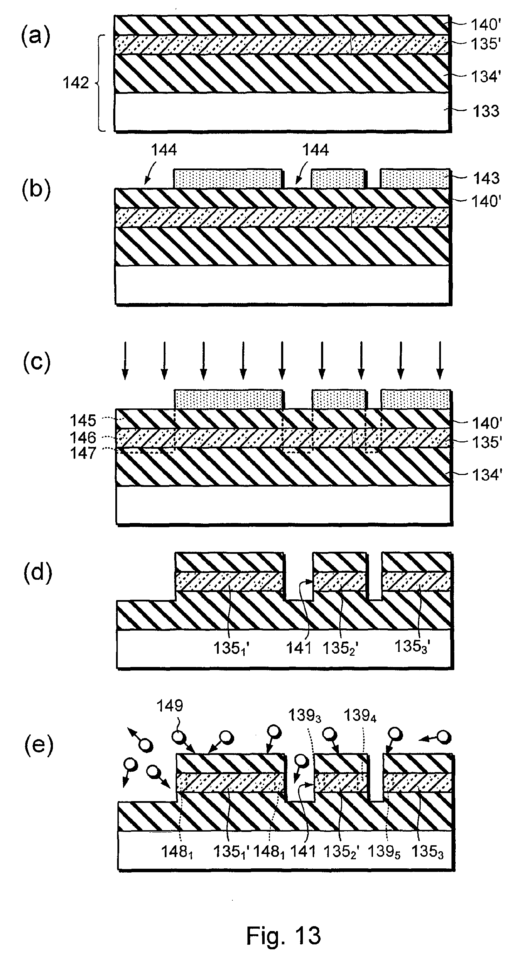

Referring to Figures 13a to 13e, a method of fabricating the device 114 will now be described.

As shown in Figure 13a, a capping layer 140' of insulating material, such as silicon dioxide, is formed on a semiconductor-on-insulator substrate 142 comprising a base 133, a buried insulator layer 134' and a semiconductor layer 135'. In this example, silicon-on-insulator is used comprising a silicon base 133, a buried oxide layer 134 and a silicon layer 135'. The capping layer 140' can be formed by thermal oxidation or deposited by chemical vapour deposition. In this example, the capping layer 140' has a thickness of at least about 5 nm, typically about 20 to 50 nm. The buried oxide layer 134' has a thickness of at least about 20 nm, typically about 50 to 200 nm. The silicon layer 135' has a thickness of about 20 to 50 nm.

As shown in Figure 13b, a patterned resist layer 143 is formed on the insulating layer 140'. For example, this may comprise applying a layer of electron-beam resist (not shown), exposing the resist to an electron beam and developing the resist. The patterned resist layer 143 have windows 144 on the capping layer 140'.

Referring to Figures 13c & 13d, reactive ion etching is used to etch through the capping layer 140' and the underlying semiconductor layer 135', and into the buried insulating layer 134' by removing portions 145 of the capping layer 140', portions 146 of the semiconductor layer 135' and surface portions of the buried insulator layer 134' in the unmasked areas 144. As shown in Figure 13d, the resulting structure leaves trench-isolated semiconductor layer regions $135_1'$, $135_2'$, $135_3'$ having exposed sidewalls 141.

Referring to Figure 13e, portions $148_1$, $148_2$, $148_3$, $148_4$, $148_5$ of the layer regions $135_1'$, $135_2'$, $135_3'$ next to exposed sidewalls 141 are converted into the insulating material, for example, by oxidation using oxygen 149.

*Operation*

Referring to Figures 6, 10, 14 and 15, operation of the device 14 as a magnetic field sensor will now be described. The second device 114 can be operated in substantially the same way, except for the orientation of the magnetic field.

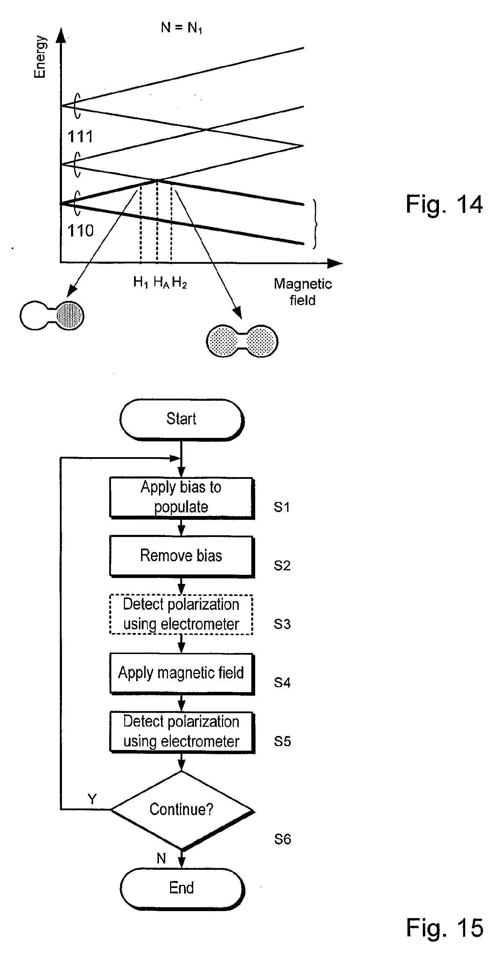

A bias, V, is applied using voltage source 27 in order to populate the double quantum dot system 18 with given number, $N = N_1$, of electrons (step S1). The bias is chosen so that there is a charge imbalance, in this case, of two electrons. The bias is removed (step S2) and, optionally, the charge polarization can be measured using the electrometer 15 (step S3). A magnetic field 32 is applied (step S4). As shown in Figure 14, if the magnetic field 32 has a magnitude, $H_1$, which is below the crossing point, $H_A$, of the energy levels 110, 111, then there is no charge redistribution. If, however, the magnetic field 32 has a magnitude, $H_2$, which exceeds the crossing point, $H_A$, of the energy levels 110, 111, then charge is redistributed resulting in a change in charge polarization. The charge polarization is measured using the electrometer 15 (step S5). This process can be repeated (step S6).

The devices 14, 114 can be used a magnetic field sensor, for example, as a read head in a hard disk drive.

Referring to Figure 16, a magnetic head slider 160 is shown. A head element portion 161 is formed on a substrate 162 and comprises a read head 163 and a write head 164. The slider 160 has an air bearing surface 165 which includes a set of stepped surfaces 166, 167, 168 including a rail surface 166, a shallow groove surface 167 and a deep groove surface 168. The slider 160 has a leading face 169 and a trailing end 170.

Referring to Figure 17, a magnetic disk drive 171 is shown. The magnetic disk drive 171 comprises a housing 172 in which a stack of magnetic disks or "media" 173 (only one is shown for clarity) are mounted to a central hub 174 driven by a spindle motor (not shown). Each magnetic disk 173 is provided with two sliders 160, one slider 170 on each side of the disk 173. Each slider 70 is attached to the tip of a respective suspension 175 which in turn are supported by respective arms 176 which are driven by an actuator 177.

The devices 14, 114 can also be used in quantum information processing.

The double-quantum dot device 14 provides a two-state system based on a highest-energy electron. Basis states for the quantum dot system 18 comprising first and second quantum dot regions $19_1$, $19_2$ which provide first and second quantum dots respectively may be defined as follows:

$|0\rangle \equiv |$ electron on the first quantum dot$\rangle$
$|1\rangle \equiv |$ electron on the second quantum dot$\rangle$

Thus, the system can be prepared with an initial state $|\Psi_i\rangle$, for example $|\Psi_i\rangle = |0\rangle$, manipulated by applying a magnetic field pulse having a magnitude, $H_A$, corresponding to the crossing point for a given duration and measuring the final state $|\Psi_f\rangle$.

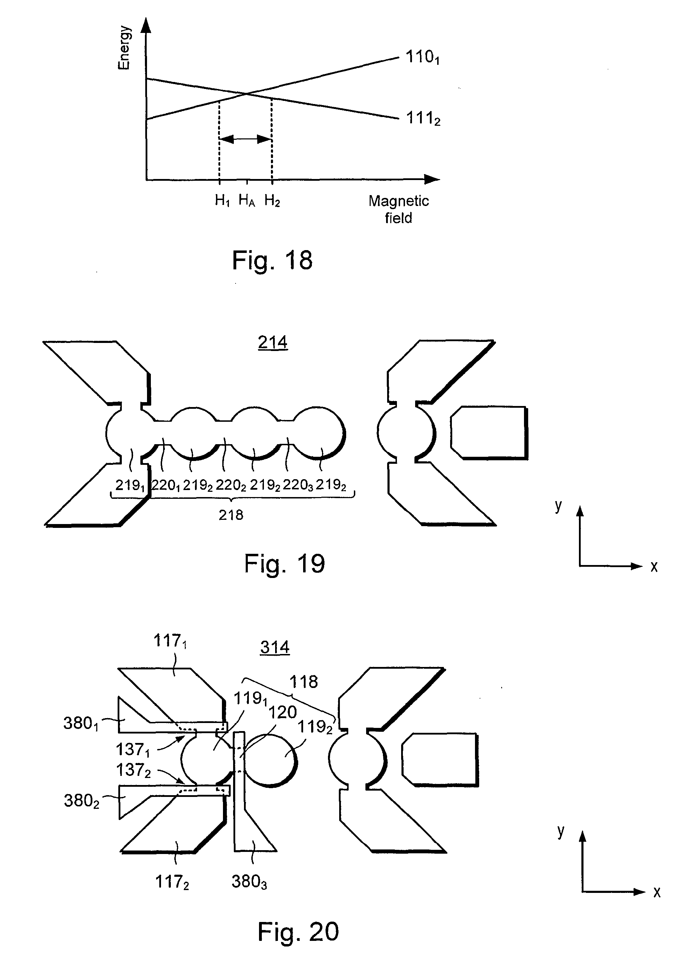

As shown in Figure 18, applying the magnetic field couples the first and second quantum dots. Thus, an electron can be exchanged between the two quantum dots.

*Further embodiments*

In the embodiments described earlier, the devices are based on two quantum dots. However, more than two quantum dots can be used.

Figure 19 shows a third embodiment of a device in accordance with the present invention. The device 214 is similar to the second device 114 (Figures 11 & 12) described earlier, but has a quantum dot system 218 which comprises four quantum dot regions $219_1$, $219_2$, $219_3$, $219_4$ and three coupling regions $120_1$, $120_2$, $120_3$. The first device 14 (Figure 7 & 8) can be modified in a corresponding way to provide a device having more than two quantum dot regions.

In the embodiments described earlier, the devices are controlled by conductive leads and an applied magnetic field. However, gate structures can be provided so as to provide additional control.

Referring to Figure 20, a fourth embodiment of a device which is responsive to a magnetic field in accordance with the present invention is shown. For clarity, associated control circuitry is not shown.

The fourth device 314 is the same as the second device shown earlier except that first and second surface gates $380_1$, $380_2$ are provided over the first and second constructions $137_1$, $137_2$ and/or a third surface gate $380_3$ is provided over the coupling region 120.

The first and second surface gates $380_1$, $380_2$ may used to control coupling between the leads $117_1$, $117_2$ and the quantum dot system 118. The third gate $380_3$ can be used to provide additional control over coupling between the quantum dot regions $119_1$, $119_2$.

The gates $380_1$, $380_2$, $380_3$ may be formed using one or more layers of non-ferromagnetic metal or metal alloy. The capping insulating layer 140 (Figure 12) can be used as a gate dielectric, although a gate dielectric may be specially provided. In some embodiments, a heavily doped semiconductor can be used instead of a metal or metal. Additional voltage sources (not shown) are provided to apply respective biases to the gates $380_1$, $380_2$, $380_3$.

In the embodiments hereinbefore described, conductive leads are used to populate a quantum dot system so as to tune the devices to respond to different magnetic fields. However, as mentioned earlier, an electric field can be used to modify the energy states of a quantum dot system and provide energy level crossing points at suitable values of applied magnetic field.

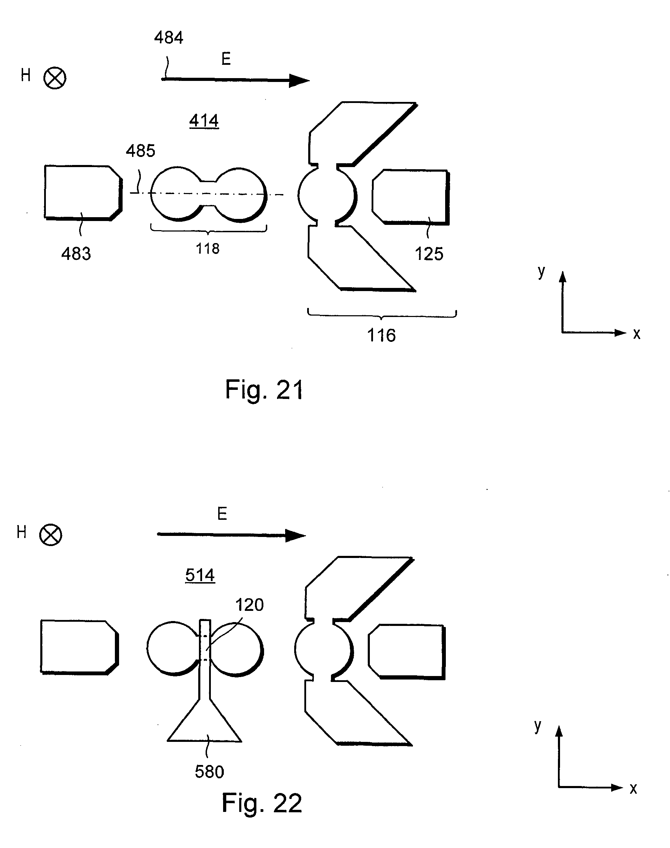

Referring to Figure 21, a fifth embodiment of a device which is responsive to a magnetic field in accordance with the present invention is shown.

The fifth device 414 is similar to the second device 114 (Figure 11 & 12) shown earlier except that the conductive leads $117_1$, $117_2$ (Figure 11) and barrier regions $121_1$, $121_2$ (Figure 11) are omitted and that a gate 483 is added. The gate 483 is in plane with the quantum dot system 418. The quantum dot system 118 is interposed between the gate 483 and the charge sensor 116. The gate 483 is arranged to apply an electric field 484 along the longitudinal axis 485 of the quantum dot system 418. Thus, the gate 483 has the effect of tilting the potential of the quantum dot system 418, i.e. there is a potential difference between the first and second quantum dots.

The gate 483 is similar to the charge sensor gate 125 and is made in a similar way.

Referring to Figure 22, a sixth embodiment of a device is responsive to a magnetic field in accordance with the present invention is shown. The sixth device 514 is similar to the fifth device 414 (Figure 21) except that a gate structure is provided surface gate 480 is provided over the coupling region 120.

It will be appreciated that many modifications may be made to the embodiments herein before described.

Different materials, layer thicknesses and device configurations may be used. For example, silicon may be doped to a different concentration. Other n-type impurities, such as arsenic, can be used. Silicon may be doped with a p-type impurity, such as boron. Other semiconducting and insulating materials can be used. For example, other silicon-based semiconducting materials, such as silicon-germanium, may be used. Non-silicon-based semiconducting materials, such as gallium arsenide (GaAs), may be used. Binary or tertiary alloys, such as gallium arsenide (GaAs), aluminium gallium arsenide (AlGaAs), indium arsenide (InAs) and gallium indium arsenide (AlInAs), may be used. In particular, devices may be formed in an GaAs/AlGaAs heterostructure providing a 2-dimensional electron gas or in a $\delta$-doped layer in GaAs. The semiconductor materials forming the quantum dot region may be undoped or doped with an impurity to a concentration less than $1 \times 10^{19}$ cm$^{-3}$.

**Claims**

1. A device comprising:

   first and second conductive leads;
   a first quantum dot region arranged such that charge is transferable from the first lead to the second lead via the first quantum dot region;
   a second quantum dot region configured such that charge is transferable between the first and second quantum dot regions and such that charge is not directly transferable from second quantum dot region to the first or second leads or to another lead; and
   a separate electrometer configured to detect charge on the second quantum dot region.

2. A device comprising:

   first and second quantum dot regions spaced apart along a given direction and configured such that charge is transferable between the first and second quantum dot regions and such that charge is not directly transferable from second quantum dot region to a lead;
   a gate arrangement configured to apply an electrical field to the first and second quantum dots along the given direction; and
   an electrometer configured to detect charge on the second quantum dot region.

3. A device according to claim 1 or 2, wherein the first and second quantum dot regions comprise first and second regions of semiconductor material configured to provide first and second quantum dots respectively.

4. A device according to claim 3, further comprising a third region of semiconducting material configured to couple the first and second quantum dot regions.

5. A device according to any preceding claim, comprising a bridge region between the first and second quantum dot regions configured so as to provide at least one zero- or one-dimensional state freely extending from the first quantum dot regions, through the bridge region, to the second quantum regions.

6. A device according to any preceding claim, wherein the electrometer comprises a single charge transistor.

7. A device according to any preceding claim, further comprising at least one additional quantum dot region including a third quantum dot region, the at least one additional quantum dot region configured such that charge is transferable between the first and third quantum dot regions via intermediate quantum dot region(s) and such that charge is not directly transferable from the intermediate quantum dot region(s) and the third quantum dot region to the first or second leads or to another lead, and wherein the electrometer is configured to detect charge on the third quantum region instead of the second quantum dot region.

8. A device according to any preceding claim, comprising means, optionally gates, for decoupling the first and second conductive leads from the first quantum dot region.

9. A device according to any preceding claim, comprising means, optionally gates, for decoupling the first and second quantum dot regions.

10. A device according to any preceding claim, further comprising:

a magnetic field source configured to apply a magnetic field in a direction which is transverse to a direction in which the first and second quantum dot regions are spaced apart.

11. Quantum information processing apparatus, the apparatus comprising at least one device according to any one of claims 1 to 10.

12. A magnetic head slider for a magnetic disk drive, the slider comprising a device according to any one of claims 1 to 10.

13. A method of operating a device comprising first and second conductive leads, a first quantum dot region arranged such that charge is transferable from the first lead to the second lead via the first quantum dot region, a second quantum dot region configured such that charge is transferable between the first and second quantum dot regions and such that charge is not directly transferable from second quantum dot region to the first or second leads or to another lead and a separate electrometer configured to detect charge on the second quantum dot region, the method comprising:

applying a bias between the first and second conductive leads;
applying a magnetic field; and
measuring charge on the second quantum dot region using the electrometer.

14. A method of operating a device comprising first and second quantum dot regions spaced apart along a given direction and configured such that charge is transferable between the first and second quantum dot regions and such that charge is not directly transferable from second quantum dot region to a lead, a gate arrangement configured to apply an electrical field to the first and second quantum dots along the given direction and an electrometer configured to detect charge on the second dot quantum region, the method comprising:

applying an electric field to the first and/or second quantum dot regions so as to raise or lower the potential of the first quantum dot region with respect to the second quantum dot region;
applying a magnetic field; and
measuring charge on the second quantum dot region using the electrometer.

15. A method according to claim 13 or 14, further comprising:

before applying the magnetic field:

decoupling the first and second quantum dot regions; and/or

before applying the magnetic field:

decoupling the first and second conductive leads from the first quantum dot region and removing the bias between the first and second conductive leads, or
removing the electric field.

**Patentansprüche**

1. Vorrichtung, die Folgendes umfasst:

erste und zweite leitende Fortführungen;
eine erste Quantenpunktregion, die so angeordnet ist, dass Ladung von der ersten Fortführung zur zweiten Fortführung über die erste Quantenpunktregion übertragen werden kann;
eine zweite Quantenpunktregion, die so konfiguriert ist, dass Ladung zwischen der ersten und zweiten Quantenpunktregion übertragen werden kann, und so, dass Ladung nicht direkt von der zweiten Quantenpunktregion zur ersten oder zweiten Fortführung oder zu einer anderen Fortführung übertragen werden kann; und
ein separates Elektrometer, das zum Erkennen von Ladung auf der zweiten Quantenpunktregion konfiguriert ist.

2. Vorrichtung, die Folgendes umfasst:

eine erste und zweite Quantenpunktregion, die entlang einer gegebenen Richtung voneinander beabstandet und so konfiguriert sind, dass Ladung zwischen der ersten und zweiten Quantenpunktregion übertragen werden kann, und so, dass Ladung nicht direkt von der zweiten Quantenpunktregion zu einer Fortführung übertragen werden kann;

eine Gatteranordnung, die zum Anlegen eines elektrischen Feldes an die ersten und zweiten Quantenpunkte entlang der gegebenen Richtung konfiguriert ist; und

ein Elektrometer, das zum Erkennen von Ladung auf der zweiten Quantenpunktregion konfiguriert ist.

3. Vorrichtung nach Anspruch 1 oder 2, wobei die erste und zweite Quantenpunktregion erste und zweite Regionen von Halbleitermaterial umfassen, das jeweils zum Bereitstellen von ersten und zweiten Quantenpunkten konfiguriert ist.

4. Vorrichtung nach Anspruch 3, die ferner eine dritte Region von Halbleitermaterial umfasst, das zum Koppeln der ersten und zweiten Quantenpunktregion konfiguriert ist.

5. Vorrichtung nach einem vorherigen Anspruch, die eine Brückenregion zwischen der ersten und zweiten Quantenpunktregion umfasst, die so konfiguriert ist, dass sie wenigstens einen null- oder eindimensionalen Zustand bereitstellt, der frei von der ersten Quantenpunktregion durch die Brückenregion zur zweiten Quantenpunktregion verläuft.

6. Vorrichtung nach einem vorherigen Anspruch, wobei das Elektrometer einen Einzelladungstransistor umfasst.

7. Vorrichtung nach einem vorherigen Anspruch, die ferner wenigstens eine zusätzliche Quantenpunktregion einschließlich einer dritten Quantenpunktregion umfasst, wobei die wenigstens eine zusätzliche Quantenpunktregion so konfiguriert ist, dass Ladung zwischen der ersten und dritten Quantenpunktregion über (eine) Zwischen-Quantenpunktregion(en) übertragen werden kann, und so, dass Ladung nicht direkt von der/den Zwischen-Quantenpunktregion(en) und der dritten Quantenpunktregion zur ersten oder zweiten Fortführung oder zu einer anderen Fortführung übertragen werden kann, und wobei das Elektrometer zum Erkennen von Ladung auf der dritten Quantenpunktregion anstatt der zweiten Quantenpunktregion konfiguriert ist.

8. Vorrichtung nach einem vorherigen Anspruch, die Mittel, optional Gatter, zum Entkoppeln der ersten und zweiten leitenden Fortführung von der ersten Quantenpunktregion umfasst.

9. Vorrichtung nach einem vorherigen Anspruch, die Mittel, optional Gatter, zum Entkoppeln der ersten und zweiten Quantenpunktregion umfasst.

10. Vorrichtung nach einem vorherigen Anspruch, die ferner Folgendes umfasst:

eine Magnetfeldquelle, die zum Anlegen eines Magnetfelds in einer Richtung quer zu einer Richtung konfiguriert ist, in der die erste und zweite Quantenpunktregion voneinander beabstandet sind.

11. Quanteninformationsverarbeitungsgerät, wobei das Gerät wenigstens eine Vorrichtung nach einem der Ansprüche 1 bis 10 umfasst.

12. Magnetkopfschieber für ein Magnetplattenlaufwerk, wobei der Schieber eine Vorrichtung nach einem der Ansprüche 1 bis 10 umfasst.

13. Verfahren zum Betreiben einer Vorrichtung, die Folgendes umfasst: erste und zweite leitende Fortführungen, eine erste Quantenpunktregion, die so angeordnet ist, dass Ladung von der ersten Fortführung zur zweiten Fortführung über die erste Quantenpunktregion übertragen werden kann, eine zweite Quantenpunktregion, die so konfiguriert ist, dass Ladung zwischen der ersten und zweiten Quantenpunktregion übertragen werden kann, und so, dass Ladung nicht direkt von der zweiten Quantenpunktregion zur ersten oder zweiten Fortführung oder zu einer anderen Fortführung übertragen werden kann, und ein separates Elektrometer, das zum Erkennen von Ladung auf der zweiten Quantenpunktregion konfiguriert ist, wobei das Verfahren Folgendes beinhaltet:

Anlegen einer Vorspannung zwischen der ersten und zweiten leitenden Fortführung;
Anlegen eines Magnetfelds; und
Messen von Ladung auf der zweiten Quantenpunktregion mit dem Elektrometer.

14. Verfahren zum Betreiben einer Vorrichtung, die Folgendes umfasst: eine erste und zweite Quantenpunktregion, die entlang einer gegebenen Richtung beabstandet und so konfiguriert sind, dass Ladung zwischen der ersten und zweiten Quantenpunktregion übertragen werden kann, und so, dass Ladung nicht direkt von der zweiten Quantenpunktregion zu einer Fortführung übertragen werden kann, eine Gatteranordnung, die zum Anlegen eines elektrischen Feldes an den ersten und zweiten Quantenpunkt entlang der gegebenen Richtung konfiguriert ist, und ein Elektrometer, das zum Erkennen von Ladung auf der zweiten Quantenpunktregion konfiguriert ist, wobei das Verfahren Folgendes beinhaltet:

Anlegen eines elektrischen Feldes an die erste und/oder zweite Quantenpunktregion, um das Potential der ersten Quantenpunktregion mit Bezug auf die zweite Quantenpunktregion zu erhöhen oder zu verringern;
Anlegen eines Magnetfeldes; und
Messen von Ladung an der zweiten Quantenpunktregion mit dem Elektrometer.

**15.** Verfahren nach Anspruch 13 oder 14, das ferner Folgendes beinhaltet:

vor dem Anlegen des Magnetfeldes:

Entkoppeln der ersten und zweiten Quantenpunktregion; und/oder

vor dem Anlegen des Magnetfeldes:

Entkoppeln der ersten und zweiten leitenden Fortführung von der ersten Quantenpunktregion und Entfernen der Vorspannung zwischen der ersten und zweiten leitenden Fortführung, oder
Entfernen des elektrischen Feldes.

**Revendications**

**1.** Dispositif comprenant :

des première et seconde sorties conductrices ;
une première région de points quantiques agencée de telle sorte qu'une charge soit transférable de la première sortie à la seconde sortie par l'intermédiaire de la première région de points quantiques ;
une deuxième région de points quantiques configurée de telle sorte qu'une charge soit transférable entre les première et deuxième régions de points quantiques et de sorte que la charge ne soit pas transférable directement de la deuxième région de points quantiques aux première ou seconde sorties ou à une autre sortie ; et
un électromètre séparé configuré pour détecter la charge sur la deuxième région de points quantiques.

**2.** Dispositif comprenant :

des première et deuxième régions de points quantiques espacées le long d'un sens donné et configurées de telle sorte qu'une charge soit transférable entre les première et deuxième régions de points quantiques et de telle sorte qu'une charge ne soit pas transférable directement de la deuxième région de points quantiques à une sortie ;
un agencement de grille configuré pour appliquer un champ électrique aux premier et second points quantiques le long du sens donné ; et
un électromètre configuré pour détecter la charge sur la deuxième région de points quantiques.

**3.** Dispositif selon la revendication 1 ou 2, dans lequel les première et deuxième régions de points quantiques comprennent des première et deuxième régions de matière semi-conductrice configurées pour fournir des premier et second points quantiques respectivement.

**4.** Dispositif selon la revendication 3, comprenant en outre une troisième région de matière semi-conductrice configurée pour coupler les première et deuxième régions de points quantiques.

**5.** Dispositif selon l'une quelconque des revendications précédentes, comprenant une région de pont entre les première et deuxième régions de points quantiques configurée pour fournir au moins un état zéro-dimensionnel ou unidimensionnel s'étendant librement depuis la première région de points quantiques, à travers la région de pont, jusqu'à la deuxième région quantique.

**EP 2 421 043 B1**

6. Dispositif selon l'une quelconque des revendications précédentes, dans lequel l'électromètre comprend un transistor à charge unique.

7. Dispositif selon l'une quelconque des revendications précédentes, comprenant en outre au moins une région de points quantiques supplémentaire comportant une troisième région de points quantiques, l'au moins une région de points quantiques supplémentaire étant configurée de telle sorte qu'une charge soit transférable entre les première et troisième régions de points quantiques par l'intermédiaire d'une ou de régions de points quantiques intermédiaires et de telle sorte qu'une charge ne soit pas directement transférable de la ou des régions de points quantiques intermédiaires et de la troisième région de points quantiques aux première ou seconde sorties ou à une autre sortie, et dans lequel l'électromètre est configuré pour détecter la charge sur la troisième région de points quantiques au lieu de la deuxième région de points quantiques.

8. Dispositif selon l'une quelconque des revendications précédentes, comprenant des moyens, éventuellement des grilles, pour découpler les première et seconde sorties conductrices de la première région de points quantiques.

9. Dispositif selon l'une quelconque des revendications précédentes, comprenant des moyens, éventuellement des grilles, pour découpler le premières et deuxièmes régions de points quantiques.

10. Dispositif selon l'une quelconque des revendications précédentes, comprenant en outre :

une source de champ magnétique configurée pour appliquer un champ magnétique dans un sens qui est transversal à un sens dans lequel les première et deuxième régions de points quantiques sont espacées.

11. Appareil de traitement d'informations quantiques, l'appareil comprenant au moins un dispositif selon l'une quelconque des revendications 1 à 10.

12. Curseur de tête magnétique de lecteur de disque magnétique, le curseur comprenant un dispositif selon l'une quelconque des revendications 1 à 10.

13. Procédé d'exploitation d'un dispositif comprenant des première et seconde sorties conductrices, une première région de points quantiques agencée de telle sorte qu'une charge soit transférable de la première sortie à la seconde sortie par l'intermédiaire de la première région de points quantiques, une deuxième région de points quantiques configurée de telle sorte qu'une charge soit transférable entre les première et deuxième régions de points quantiques et de telle sorte qu'une charge ne soit pas transférable directement de la deuxième région de points quantiques aux première ou seconde sorties ou à une autre sortie et un électromètre séparé configuré pour détecter une charge sur la deuxième région de points quantiques, le procédé comprenant :

l'application d'une polarisation entre les première et seconde sorties conductrices ;
l'application d'un champ magnétique ; et
la mesure de la charge sur la deuxième région de points quantiques au moyen de l'électromètre.

14. Procédé d'exploitation d'un dispositif comprenant des première et deuxième régions de points quantiques espacées le long d'un sens donné et configurées de telle sorte qu'une charge soit transférable entre les première et deuxième régions de points quantiques et de telle sorte qu'une charge ne soit pas transférable directement de la deuxième région de points quantiques à une sortie, un agencement de grille configuré pour appliquer un champ électrique aux premier et second points quantiques le long du sens donné et un électromètre configuré pour détecter une charge sur la deuxième région de points quantiques, le procédé comprenant :

l'application d'un champ électrique sur les première et/ou deuxième régions de points quantiques de manière à augmenter ou réduire le potentiel de la première région de points quantiques relativement à la deuxième région de points quantiques ;
l'application d'un champ magnétique ; et
la mesure d'une charge sur la deuxième région de points quantiques au moyen de l'électromètre.

15. Procédé selon la revendication 13 ou 14, comprenant en outre :

avant l'application du champ magnétique :

le découplage des première et deuxième régions de points quantiques ; et/ou

avant l'application du champ magnétique :

le découplage des première et seconde sorties conductrices de la première région de points quantiques et la suppression de la polarisation entre les première et seconde sorties conductrices, ou la suppression du champ électrique.

Fig. 1

Fig. 2

Fig. 3a

Fig. 3b

Fig. 4a

Fig. 4b

Fig. 5a

Fig. 5b

Fig. 6

Fig. 6a

Fig. 6b

Fig. 7

Fig. 8

**Fig. 9**

Fig. 9

(k)

$43_1$  $43_2$  $43_3$

42

(l)

$43_1$  $43_2$  $43_3$

44

(m)

45'
44

(n)

56  57

45'

(o)

58

45'

Fig. 9

Fig. 10

Fig. 11

Fig. 12

Fig. 13

N = N$_1$

Energy

111

110

H$_1$ H$_A$ H$_2$

Magnetic field

Fig. 14

Start

Apply bias to populate — S1

Remove bias — S2

Detect polarization using electrometer — S3

Apply magnetic field — S4

Detect polarization using electrometer — S5

Continue? — S6

Y

N

End

Fig. 15

160

170

79

164 163

168

165

167

166

162

169

**Fig. 16**

171

173

174

160

172

176 175

177

**Fig. 17**

Fig. 18

Fig. 19

Fig. 20

Fig. 21

Fig. 22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1341079 A2
- EP 1262911 A
- EP 1860600 A
- EP 2075745 A

**Non-patent literature cited in the description**

- **NOBUYOSHI TAKAHASHI ; HIROKI ISHIKURO ; TOSHIRO HIRAMOTO.** A Directional Current Switch Using Silicon Single Electron Transistors Controlled by Charge Injection into Silicon Nano-Crystal Floating Dots. *Electron Devices Meeting, 1999, IEDM Technical Digest,* 1999, 371-374
- **C. YANNOULEAS ; U. LANDMAN.** Symmetry breaking and quantum correlations in finite systems: studies of quantum dots and ultracold Bose gases and related nuclear and chemical methods. *Reports on Progress in Physics,* 2007, vol. 70, 2067-2148
- **P. STANO ; J. FABIAN.** Spin-orbit effects in single-electron states in coupled quantum dots. *Physical Review B,* 2005, vol. 72, 155410ff
- **M. HELLE ; A. HARJU ; R. M. NIEMINEN.** Two-electron lateral quantum-dot molecules in a magnetic field. *Physical Review B,* 2005, vol. 72, 205329ff
- **W. G. VAN DER WIEL ; S. DE FRANCESCHI ; J. M. ELZERMAN ; T. FUJISAWA ; S. TARUCHA ; L. P. KOUWENHOVEN.** Electron transport through double quantum dots. *Reviews of Modern Physics,* 2003, vol. 75 (1), 1-22
- **T. HATANO ; M. STOPA ; S. TARUCHA.** Single-Electron Delocalization in Hybrid Vertical-Lateral Double Quantum Dots. *Science,* 2005, vol. 309, 268ff
- **R. M. ABOLFATH ; P. HAWRYLAK ; M. PIOXO-LADXIERE ; A. SACHRAJDA.** Quantum Hall droplets in coupled lateral quantum dots. *Physica E,* 2006, vol. 34, 636-639
- **S. KAWAGUCHI.** Effect of a side-connected dot in a T-shaped double quantum dot interferometer. *Journal of Physics: Condensed Matter,* 2008, vol. 20, 195205ff